# EUROPEAN PATENT SPECIFICATION

(11) **EP 1 041 389 B1**
(45) Date of publication and mention of the grant of the patent: **14.08.2002**
(21) Application number: 99106658.0
(22) Date of filing: 01.04.1999
(51) Int. Cl.: G01R 27/06, G01R 31/316

(54) **System and method for characterising a test fixture**
System und Verfahren zur Prüfhalterungscharakterisierung
Système et procédé pour caractériser un châssis d'essais

(43) Date of publication of application: 04.10.2000
(73) Proprietor: Advantest (Europe) GmbH, 81929 München (DE)
(72) Inventor: Methe, Walter, 86825 Bad Wörishofen (DE); Helmreich, Klaus, 90518 Altdorf (DE); Achatz, Hermann, 85748 Garching-Hochbrück (DE); Köppl, Josef, 94239 Zachenberg (DE); Lechner, Armin, 80805 Müunchen (DE)
(74) Representative: Tetzner, Volkmar, Dr.-Ing. Dr. jur.

(56) References cited:
- SMITH D H ET AL: "High-speed characteristics of multilayer ceramic packages and test fixtures" 12TH ANNUAL GAAS IC SYMPOSIUM. TECHNICAL DIGEST 1990 (CAT. NO.90CH2889-4), NEW ORLEANS, LA, USA, 7-10 OCT. 1990, pages 203-206, XP002114447 1990, New York, NY, USA, IEEE, USA
- VIRTUE M ET AL: "TRL calibration sharpens MM-wave wafer measurements" MICROWAVES & RF, OCT. 1988, USA, vol. 27, no. 10, pages 77-84, XP002114448 ISSN: 0745-2993
- MCTIGUE M M ET AL: "DIFFERENTIAL TIME-DOMAIN REFLECTOMETRY MODULE FOR A DIGITAL OSCILLOSCOPE AND COMMUNICATIONS ANALYZER" HEWLETT-PACKARD JOURNAL, vol. 47, no. 6, 1 December 1996 (1996-12-01), pages 32-36, XP000685940
- PEREZALONSO F ET AL: "Electrical characterization of VLSI packages" 1991 PROCEEDINGS. 41ST ELECTRONIC COMPONENTS AND TECHNOLOGY CONFERENCE (CAT. NO.91CH2989-2), ATLANTA, GA, USA, 11-16 MAY 1991, pages 62-69, XP002114449 1991, New York, NY, USA, IEEE, USAISBN: 0-7803-0012-2

## Description

The invention consists of a system and a method for characterising a test fixture, this test fixture having multi channel connecting means for connecting a multi channel test system (ATE) to at least one integrated circuit.

In order to test an integrated circuit, it is mounted onto a test fixture and the test fixture is connected to a multi channel test system (ATE), which provides test signals or test sequences and receives responses from the integrated circuit. The test fixture is a means for the electrical connection of one or more integrated circuits to the test system (ATE) including cables and printed circuit boards.

A typical test fixture connects to the multi channel test system (ATE) by a number of multiple channel connectors. These are mounted on a printed circuit board, called performance board hereafter, which connects each channel of the multiple channel connectors to a cable. These cables lead to one or more printed circuit boards, called socket boards hereafter, which carry sockets for the integrated circuits to be tested.
Test fixtures for contacting integrated circuits on the wafer include contact elements such as needle probes mounted on a printed circuit board, called probe card hereafter.

The channel assignment is stored in a data file and contains the information, which channel of the test system (ATE) leads to which pin of the integrated circuit.

In order to obtain reliable results when testing integrated circuits via a test fixture, a good performance of the test fixture is essential. Therefore, before using a test fixture, it has to be characterized. Up to now, the characterisation of a test fixture has been performed manually or with the target test system (ATE). The characterisation was limited to checking the continuity, isolation and propagation delay of the signal path.

Smith et al: "High-speed characteristics of multilayer ceramic packages and test fixtures", 12th Annual Gaas IC Symposium. Technical digest 1990 (CAT NO.90CH2889-4), New Orleans, LA, USA, 7-10 Oct. 1990, pages 203-206, describes the high-speed electrical characteristics of a typical multilayer cheramic package and presents a model. The tests were conducted in a realistic environment which closely models the surface mount environment for which packages are intended. In the measurements, a test fixture for the MLC package is used which closely emulates a system environment. During the measurements traditional time domain measurements were performed. Before testing the package, the test fixture was tested without the package to determine the transitory point from the test fixture to the package.

The use of time domain reflectometers as well as sweeping reflection and or transmission test equipment for checking or characterising cables, components or other DUTs is also known from Virtue M. et al: "TRL calibration sharpens MM-wave wafer measurements", MICROWAVS & RF, Oct. 1988, USA, Vol.27, No.10, pages 77-84, XP002114448 ISSN: 0745-2993; McTigue M. M. et al: "Differential Time-Domain Reflectometry Module for a Digital Oscilloscope and Communications Analyzer", Hewlett-Packard Journal, December 1996, pages 32-36, XP000685940; and Perezalonso F. et al "Electrical Characterization of VLSI Packages", XP00211449, 1999.

The object of the invention is to facilitate and improve the system and the method for characterising a test fixture.

The features of claims 1 and 16 achieve this object. Further embodiments of the inventiona are the subject matter of the subordinate claims.

According to the invention the system for characterising a test fixture comprises a reflection and/or transmission test device operating in the frequency and/or time domain. Furthermore, the system has means for connecting the test fixture to the reflection and/or transmission test device. Accordingly, it is possible to measure and analyse the reflection and/or transmission characteristics with time variable stimuli in the frequency and/or time domain. The connecting means comprises a switch matrix for connecting the test device with one or more specific connections of the multichannel connecting means. It is possible to analyse the type and location of a fault in the test fixture.

Further advantages and embodiments of the invention are explained in greater detail with reference to the following description of an embodiment and the drawings, in which:
- Fig. 1: shows a schematic representation of the system for characterising a test fixture,
- Fig. 2: a schematic representation of the means for connecting the test fixture to the reflection and/or transmission test device,
- Fig. 3: shows a diagram of result analysis and
- Fig. 4: shows a schematic representation of an additional DC test device of the system for characterising a test fixture.

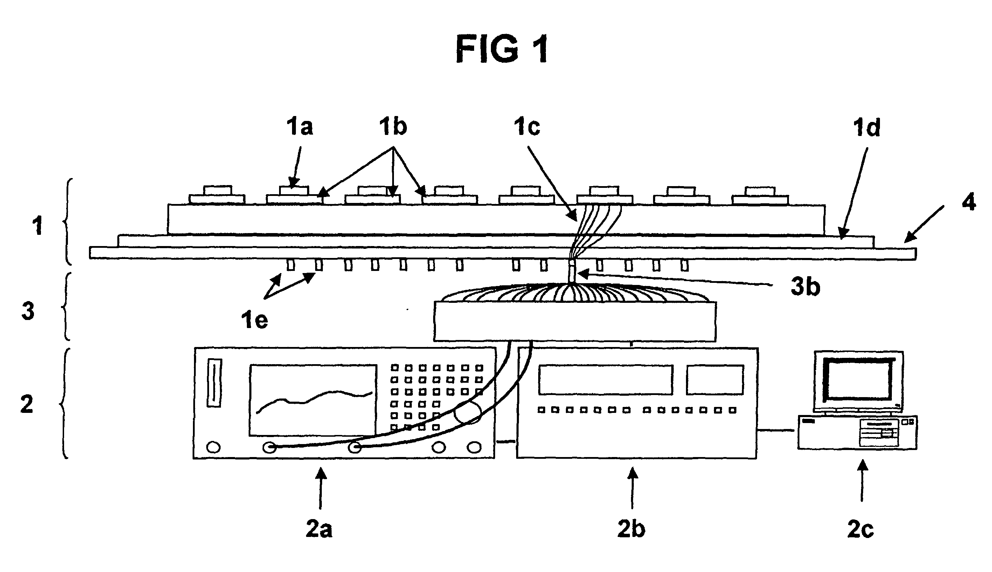

Fig. 1 shows a system for characterising test fixture 1, the test fixture having multi channel connecting means for connecting, in normal usage, several integrated circuits to a multi channel test system (ATE). Furthermore, it comprises of a reflection and/or transmission test device 2 operating in the frequency and/or time domain. Means 3 is used for connecting the test fixture 1 to the reflection and/or transmission test device 2.

The multi channel connecting means of the test fixture 1 comprise of one or more sockets 1a mounted on socket boards 1b, connecting cables 1c, usually coaxial cables, a performance board 1d with connectors 1e, especially ZIF-connectors. The test fixture described above is known in the art.

The test device 2 comprises a vector network analyser 2a, a controller 2b and a computer 2c.

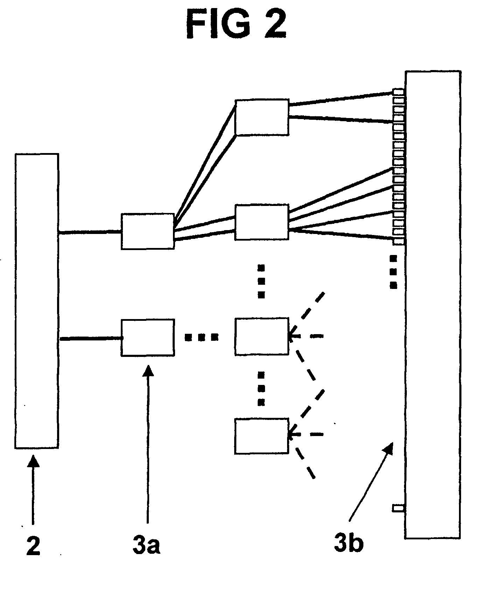

The connecting means 3 may comprise a prober tip for reliably connecting to one socket contact after another. Preferably, however, the connecting means are realised by a RF switch matrix using wave-guide relays 3a, as shown in Fig. 2. In the embodiment according to Fig. 2, two measurement ports of the test device 2 are connected via wave-guide relays 3a to an interface 3b. The interface 3b of the connecting means 3 is connected to the multi channel connector 1e of the test fixture. By controlling the wave-guide relays 3a, it is possible to connect the test device 2 to one specific connection of connector 1e. The connection between the interface, the wave-guide relays and the test devices, respectively, is formed by coaxial cables.

To suit other applications of the test fixtures to be characterised the interface 3b is replaceable in order to adapt it to the connector 1e of the test fixture.

The connecting means 3 in the embodiment shown in Fig. 1 connects the test device 2 to connector 1e of the test fixture. If there are more connectors 1e, as shown here, it is necessary to shift the test fixture 1 relative to the connection means 3, in order to establish a contact with another connector 1e. Such means for relative shifting can be carried out by a step and alignment frame 4 in combination with a positioning code on the test fixture. Furthermore, means for heating or cooling the test fixture may be provided.

The method for characterising a test fixture 1 using the system set out above will now be described in more detail.

Before measurements, however, a system error correction at the measurement plane, has to be carried out.

By connecting the multiple channel connector 1e of the test fixture to the reflection and/or transmission test device 2 one or more at a time, it is possible to measure and analyse the reflection and/or transmission characteristics with time variable stimuli in the frequency and/or time domain.

The controller 2b, which is operated by the computer 2c, controls the wave-guide relays 3a of the connecting means 3 in that the network analyser 2a is connected via the wave-guide relays 3a to a certain connection of a specific connector 1e in the test fixture. The computer 2c operates the controller 2b and the network analyser 2a and analyses the signals received from the test. The extracted parameters are compared with the reference values. Analysis identifies the type and location of a fault.

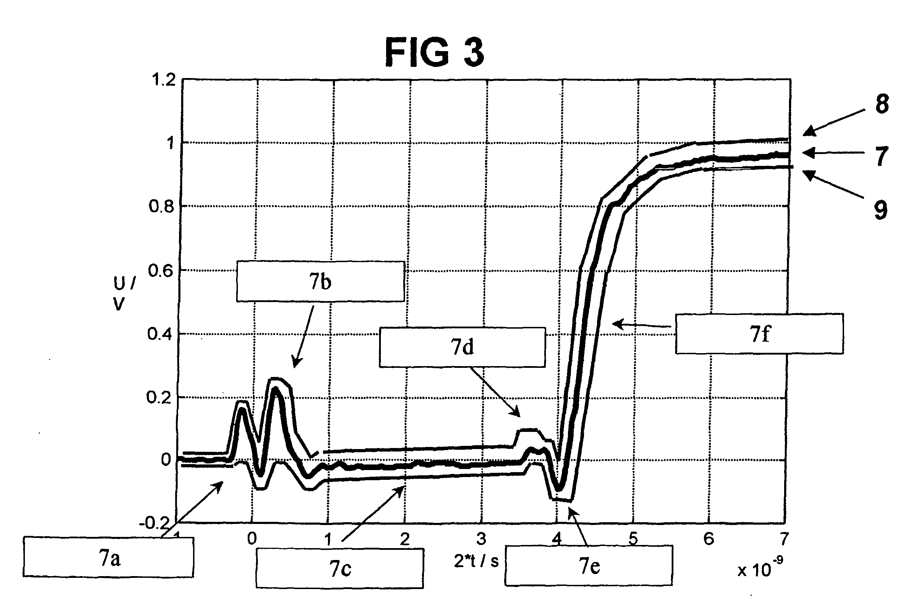

Fig. 3 shows a diagram, which is the result of a reflection test and its analysis. Curve 7 results from the test whilst curves 8 and 9 are upper and lower reference values. Curve 7 has to be within this gauge to pass the test. The curve gives detailed information about the test fixture. The interesting parts of curve 7 are marked with reference signs 7a to 7f and will give the following information.
7a interface 3b;
7b connection of interface 3b and connector 1e of test fixture;
7c length of the cable 1c;
7d socket board 1b;
7e socket 1a
7f rise time which identifies signal performance.

With the help of the reflectometry and especially the diagram shown in Fig. 3 it is possible to detect the following faults: untypical connectors, bad soldering on performance boards, wrong cable (type, length), defective cable, bad soldering on socket board, electrical length and character of socket board, connection to socket, character of socket, etc. Using a test fixture for wafer probing, the list of the detectable faults has to be continued with: pogo pin connection, probe card lines, length and impedance of needle probes, etc.

Furthermore, an impedance measurement for each voltage supply path is possible.

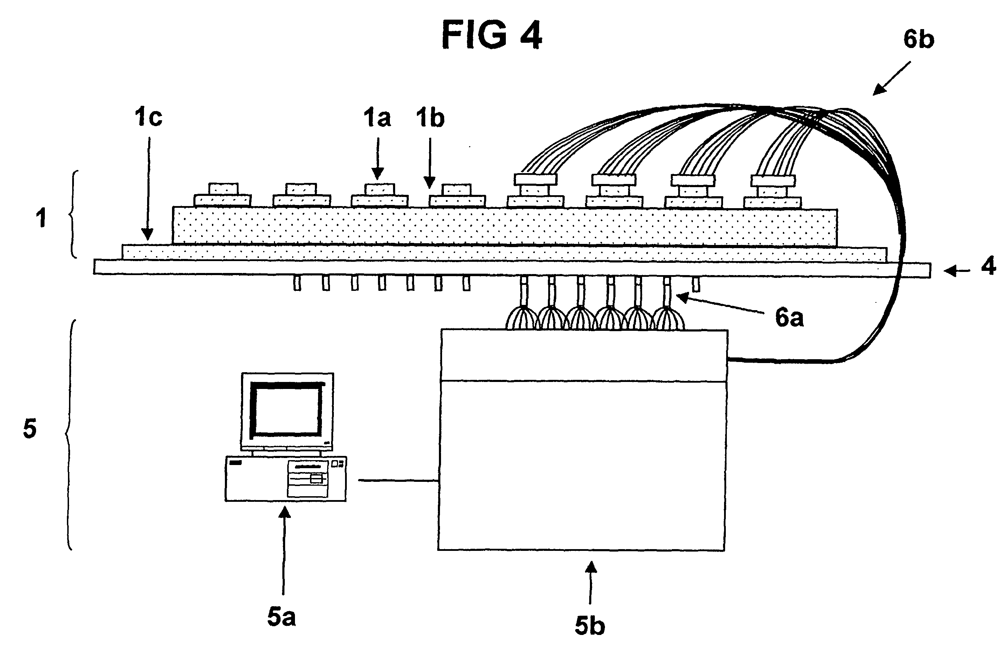

The system and method for characterising a test fixture described until now uses the reflectometry (frequency domain reflectometry or time domain reflectometry) for each connector channel.
The system for characterising a test fixture may also comprise of a DC test device as disclosed in Fig. 4. This test device comprises a controller 5b and a computer 5a. In addition, there are means 6a for connecting the test fixture 1 on the multi channel test system (ATE) side and means 6b for connecting the test fixture 1 on the integrated circuit side to the DC test device 5.

A DC test device 5 is a high voltage tester that preferably produces high voltage test signals of at least 100 V.
The DC test device 5 is adapted to measure at least one or more of the following characteristics:
- signal continuity of the channels of the multi channel connecting means,
- correct arrangements of the channels of the multi channel connecting means,
- leakage,
- isolation of channel to ground,
- isolation of channel to channel,
- dielectric strength,
- voltage capability,
- impedance,
- capacity and
- signal continuity.

The arrangements of the channels of the multi channel connecting means of the test fixture between the test system side (ATE) and the integrated circuit side are usually stored in the test system (ATE). These data will automatically configure the test device 2.

The system and method as described above allow very detailed reporting of the characteristics of the test fixture. Using a characterised test fixture and its data, the multi channel test system (ATE) tests integrated circuits more accurately.

## Claims

1. System for **characterising** a test fixture (1), the test fixture having multi channel connecting means for connecting a multi channel test system (ATE) to at least one integrated circuit,
**characterised by**
- a reflection and/or transmission test device (2) operating in the frequency and/or time domain
- and means (3), comprising a switch matrix, for connecting the test device (2) with one or more specific connections of the multi channel connecting means.

2. System according to claim 1, whereby the test device (2) comprises a vector network analyser.

3. System according to claim 1, **characterised in that** the connecting means (3) comprise of wave-guide relays (3a).

4. System according to claim 1, **characterised in that** the connecting means (3) comprise of a prober tip for reliable connection of one channel of the multi channel connecting means after another.

5. System according to claim 1, **characterised in that** the connecting means (3) comprise an interface (3b) which is replaceable in order to adapt it to a connector (1e) of the test fixture (1).

6. System according to claim 1, further **characterised by** a DC test device (5).

7. System according to claim 6, **characterised in that** the DC test device (5) comprises means (6a) for connecting the test fixture (1) on the multi channel test system (ATE) side and means (6b) for connecting the test fixture on the integrated circuit side with the DC test device (5).

8. System according to claims 6 and 7, **characterised by** the DC test device is adapted to ensure the correct arrangement of the connector channels (1a).

9. System according to one or more of the claims 6 to 8, **characterised in that** the DC test device is adapted to measure leakage.

10. System according to one or more of the claims 6 to 9, **characterised by** the DC test device is adapted to measure isolation.

11. System according to one or more of the claims 6 to 10, **characterised in that** the DC test device is adapted to use high voltage test signals.

12. System according to one or more of claims 6 to 11, **characterised by** the DC test device is adapted to measure dielectric strength.

13. System according to one or more of claims 6 to 12, **characterised in that** the DC test device is adapted to measure impedance.

14. System according to one or more of claims 6 to 13, **characterised by** the DC test device is adapted to measure capacity.

15. System according to one of the preceding claims, **characterised in that** there are means for heating or cooling the test fixture.

16. Method for **characterising** a test fixture (1), the test fixture having multi channel connecting means for connecting a multi channel test system (ATE) to at least one integrated circuit,
**characterised by**
measurement and analysis of the reflection and/or transmission characteristics with time variable stimuli in the frequency and/or time domain,
the test device being connected with one ore more specific connections of the multi channel connecting means via a switch matrix.

17. Method according to claim 16, **characterised in that** the measurement results will be compared with reference values.

18. Method according to claim 16, **characterised by** the type and location of a fault is analysed.

19. Method according to claim 16, **characterised in that** the arrangements of the multi channel connecting means between the test system (ATE) and the integrated circuits are configured automatically by using data of the test system.

20. Method according to claim 16, **characterised in that** the channels of the multi channel connecting means are tested with respect to an unintentional connection between each other or between the channel and ground.

21. Method according to claim 16, **characterised in that** the system provides test data of the test fixture for usage in the multi channel test system (ATE).

## Patentansprüche

1. System zur Charakterisierung einer Testvorrichtung (1), die Mehrkanalverbindungsmittel zur Verbindung eines Mehrkanaltestsystems (ATE) mit wenigstens einer integrierten Schaltung aufweist,
**gekennzeichnet durch**
- ein Reflektions- und/oder Transmissionsprüfgerät (2), welches im Frequenz- und/oder Zeitbereich arbeitet,
- und Mittel (3), enthaltend eine Schaltmatrix, um das Prüfgerät (2) mit ein oder mehreren bestimmten Anschlüssen der Mehrkanalverbindungsmittel zu verbinden.

2. System nach Anspruch 1, wobei die Prüfvorrichtung einen Vektoranalysator aufweist.

3. System nach Anspruch 1, **dadurch gekennzeichnet, daß** die Verbindungsmittel (3) Wellenleiterrelais (3a) umfassen.

4. System nach Anspruch 1, **dadurch gekennzeichnet, daß** die Verbindungsmittel (3) eine Prüfsonde für einen zuverlässigen Anschluß eines Kanals der Mehrkanalverbindungsmittel nach dem anderen umfaßt.

5. System nach Anspruch 1, **dadurch gekennzeichnet, daß** die Verbindungsmittel (3) ein Interface (3b) umfassen, welches austauschbar ist, um es an eine Anschlußeinheit (le) der Testvorrichtung (1) anzupassen.

6. System nach Anspruch 1, weiterhin **gekennzeichnet durch** ein Gleichstromprüfgerät (5).

7. System nach Anspruch 6, **dadurch gekennzeichnet, daß** das Gleichstromprüfgerät (5) Mittel (6a) zur Verbindung der Testvorrichtung (1) auf der Seite des Mehrkanaltestsystems (ATE) und Mittel (6b) zur Verbindung der Testvorrichtung auf der Seite der integrierten Schaltung mit dem Gleichstromprüfgerät (5) enthält.

8. System nach Anspruch 6 und 7, **dadurch gekennzeichnet, daß** das Gleichstromprüfgerät so ausgebildet ist, daß die richtige Anordnung der Anschlußkanäle (1a) überprüft werden kann.

9. System nach einem oder mehreren der Ansprüche 6 bis 8, **dadurch gekennzeichnet, daß** das Gleichstromprüfgerät zur Messung des Leckstroms ausgebildet ist.

10. System nach einem oder mehreren der Ansprüche 6 bis 9, **dadurch gekennzeichnet, daß** das Gleichstromprüfgerät zur Isolationsmessung ausgebildet ist.

11. System nach einem oder mehreren der Ansprüche 6 bis 10, **dadurch gekennzeichnet, daß** das Gleichstromprüfgerät zur Verwendung von Hochspannungstestsignalen ausgebildet ist.

12. System nach einem oder mehreren der Ansprüche 6 bis 11, **dadurch gekennzeichnet, daß** das Gleichstromprüfgerät zur Messung der dielektrischen Stärke ausgebildet ist.

13. System nach einem oder mehreren der Ansprüche 6 bis 12, **dadurch gekennzeichnet, daß** das Gleichstromprüfgerät zur Messung der Impedanz ausgebildet ist.

14. System nach einem oder mehreren der Ansprüche 6 bis 13, **dadurch gekennzeichnet, daß** das Gleichstromprüfgerät zur Messung der Kapazität ausgebildet ist.

15. System nach einem der vorhergehenden Ansprüche, **dadurch gekennzeichnet, daß** Mittel zum Erhitzen oder Kühlen der Testvorrichtung vorgesehen sind.

16. Verfahren zur Charakterisierung einer Testvorrichtung (1), die Mehrkanalverbindungsmittel zur Verbindung eines Mehrkanaltestsystems (ATE) mit wenigstens einer integrierten Schaltung aufweist,
**gekennzeichnet durch** die Messung und Analyse von Reflektions- und/oder Transmissionseigenschaften mit zeitvariablen Impulsen im Frequenz- und/oder Zeitbereich, wobei die Prüfvorrichtung mit einem oder mehreren bestimmten Anschlüssen der Mehrkanalverbindungsmittel über eine Schaltmatrix verbunden ist.

17. Verfahren nach Anspruch 16, **dadurch gekennzeichnet, daß** die Meßergebnisse mit Referenzwerten verglichen werden.

18. Verfahren nach Anspruch 16, **dadurch gekennzeichnet, daß** die Art und der Ort eines Fehlers analysiert werden.

19. Verfahren nach Anspruch 16, **dadurch gekennzeichnet, daß** die Anordnungen der Mehrkanalverbindungsmittel zwischen dem Testsystem (ATE) und den integrierten Schaltungen automatisch unter Verwendung von Daten des Testsystems konfiguriert werden.

20. Verfahren nach Anspruch 16, **dadurch gekennzeichnet, daß** die Kanäle der Mehrkanalverbindungsmittel auf eine unbeabsichtigte Verbindung zwischen einander oder zwischen Kanal und Masse geprüft werden.

21. Verfahren nach Anspruch 16, **dadurch gekennzeichnet, daß** das System Testdaten der Testvorrichtung für die Verwendung im Mehrkanaltestsystem (ATE) bereitstellt.

## Revendications

1. Système pour **caractériser** un châssis d'essais (1), le châssis d'essais comportant des moyens de connexion à canaux multiples pour connecter un système d'essais à canaux multiples (ATE) sur au moins un circuit intégré,
**caractérisé par**
- un dispositif d'essais de réflexion et/ou de transmission (2) fonctionnant dans le domaine fréquence et/ou temps
- et des moyens (3), comprenant une matrice de commutation, pour connecter le dispositif d'essais (2) avec une ou plusieurs connexions spécifiques des moyens de connexion à canaux multiples.

2. Système selon la revendication 1, le dispositif d'essais (2) comprenant un analyseur de réseau de vecteur.

3. Système selon la revendication 1, **caractérisé en ce que** les moyens de connexion (3) comprennent des relais de guide d'ondes (3a).

4. Système selon la revendication 1, **caractérisé en ce que** les moyens de connexion (3) comprennent une pointe de sondeur ou pointe d'essai en vue de la connexion fiable d'un canal des moyens de connexion à canaux multiple, l'un après l'autre.

5. Système selon la revendication 1, **caractérisé en ce que** les moyens de connexion (3) comprennent une interface (3b) qui peut être remplacée pour l'adapter à un connecteur (1^{e}) du dispositif d'essais (1).

6. Système selon la revendication 1, **caractérisé** de plus par un dispositif de test courant continu (5).

7. Système selon la revendication 6, **caractérisé en ce que** le dispositif d'essais courant continu (5) comprend des moyens pour connecter le châssis d'essais (1) sur le côté du système d'essais à canaux multiples (ATE) et des moyens (6b) pour connecter le châssis d'essais sur le côté de circuit intégré avec le dispositif d'essais de courant continu (5).

8. système selon les revendications 6 et 7, **caractérisé en ce que** le dispositif d'essais de courant continu est apte à assurer un bon agencement des canaux de connecteur (1a).

9. Système selon une ou plusieurs des revendications 6 à 8, **caractérisé en ce que** le dispositif d'essais de courant continu est apte à mesurer les fuites.

10. Système selon une ou plusieurs des revendications 6 à 9, **caractérisé en ce que** le dispositif d'essais de courant continu est apte à mesurer l'isolation.

11. Système selon une ou plusieurs des revendications 6 à 10, **caractérisé en ce que** le dispositif d'essais de courant continu est apte à utiliser les signaux d'essais haute tension.

12. Système selon une ou plusieurs des revendications 6 à 11, **caractérisé en ce que** le dispositif d'essais de courant continu est apte à mesurer la résistance diélectrique.

13. Système selon une ou plusieurs des revendications 6 à 12, **caractérisé en ce que** le dispositif d'essais de courant continu est apte à mesurer l'impédance.

14. Système selon une ou plusieurs des revendications 6 à 13, **caractérisé en ce que** le dispositif d'essais de courant continu est apte à mesurer la capacité.

15. Système selon une ou plusieurs des revendications précédentes, **caractérisé en ce que** sont prévus des moyens pour chauffer ou refroidir le châssis d'essais.

16. Procédé pour **caractériser** un châssis d'essais (1), le châssis d'essais comportant des moyens de connexion à canaux multiples pour connecter un système d'essais à canaux multiples (ATE) à au moins un circuit intégré,
**caractérisé par**
la mesure et l'analyse des caractéristiques de réflexion et/ou de transmission avec des stimuli de variable de temps dans le domaine fréquence et/ou temps,
le dispositif d'essais étant connecté à une ou plusieurs connexions spécifiques des moyens de connexion à canaux multiples par l'intermédiaire d'une matrice de commutateur.

17. Procédé selon la revendication 16, **caractérisé en ce que** les résultats des mesures seront comparés à des valeurs de référence.

18. Procédé selon la revendication 1, **caractérisé par** l'analyse du type et de l'emplacement d'un défaut.

19. Procédé selon la revendication 16, **caractérisé en ce que** les agencements des moyens de connexion à canaux multiples entre le système d'essais (ATE) et les circuits intégrés sont configurés automatiquement en utilisant les données du système d'essais.

20. Procédé selon la revendication 16, **caractérisé en ce que** les canaux des moyens de connexion à canaux multiples sont testés à l'égard d'une connexion non intentionnelle entre eux ou entre le canal et la terre.

21. Procédé selon la revendication 16, **caractérisé en ce que** le système fournit des données d'essais du châssis d'essais pour l'utilisation dans le système d'essais à canaux multiples (ATE).
